# EUROPÄISCHE PATENTSCHRIFT

(11) **EP 2 171 490 B1**
(45) Veröffentlichungstag und Bekanntmachung des Hinweises auf die Patenterteilung: **28.02.2018**
(21) Anmeldenummer: 08758765.5
(22) Anmeldetag: 26.05.2008
(51) Int. Cl.: G01R 31/3193, G01R 31/317, H04L 7/033

(54) **VERFAHREN ZUR SYNCHRONISATION VON MEHREREN MESSKANALBAUGRUPPEN UND/ODER MESSGERÄTEN SOWIE ENTSPRECHENDES MESSGERÄT**
METHOD FOR SYNCHRONIZING A PLURALITY OF MEASURING CHANNEL ASSEMBLIES AND/OR MEASURING DEVICES, AND APPROPRIATE MEASURING DEVICE
PROCÉDÉ POUR LA SYNCHRONISATION DE PLUSIEURS MODULES DE VOIES DE MESURE ET/OU INSTRUMENTS DE MESURE ET INSTRUMENT DE MESURE CORRESPONDANT

(30) Priorität: 26.07.2007 DE 102007034988; 27.09.2007 DE 102007046300
(43) Veröffentlichungstag der Anmeldung: 07.04.2010
(73) Patentinhaber: Rohde & Schwarz GmbH & Co. KG, 81671 München (DE)
(72) Erfinder: HOLZMANN, Gottfried, 85604 Zorneding (DE); MITTERMAIER, Werner, 85435 Erding (DE); STEINEGGER, Anton, 81825 München (DE)
(74) Vertreter: Beder, Jens
(86) Internationale Anmeldenummer: PCT/EP2008/004178
(87) Internationale Veröffentlichungsnummer: WO 2009/012834

(56) Entgegenhaltungen:
- US-A- 4 928 278
- US-A1- 2007 168 766

## Beschreibung

Die Erfindung betrifft ein Verfahren zur Synchronisation von mehreren Messkanalbaugruppen zumindest eines Messgeräts, mehreren Messgeräten sowie entsprechende Messgeräte.
Messungen z.B. bei modernen Mobilfunksystemen werden bislang durch Mobilfunkmessgeräte durchgeführt, die entweder einkanalig oder mehrkanalig mit einer relativ ungenauen Synchronisierung betrieben werden. Die Synchronisierung erfolgt über ein Synchronisationssignal im Bereich von beispielsweise 10 MHz. Eine solche Synchronisierung ist jedoch für die Messung bei modernen Mobilfunkverfahren nicht ausreichend. Hierbei ist eine Synchronisation mit einer Genauigkeit von weniger als 10 Nanosekunden erforderlich.
Es ist daher die Aufgabe der vorliegenden Erfindung ein Verfahren zur Synchronisierung von mehreren Messkanalbaugruppen eines Messgeräts, mehrerer Messgeräte sowie entsprechende Messgeräte zu schaffen, dessen Synchronisation gegenüber dem bekannten Messgerät verbessert ist.

Die Aufgabe wird durch ein erfindungsgemäßes Messgerät mit den Merkmalen des Anspruchs 12 sowie ein Verfahren mit den Merkmalen des Anspruchs 1 gelöst.
Das erfindungsgemäße Messgerät zur Synchronisation von mehreren Messkanalbaugruppen umfasst zumindest zwei Messkanalbaugruppen In dem Messgerät wird ein Taktsignal durch eine Taktsignalquelle erzeugt. Die das Taktsignal erzeugende Taktsignalquelle ist mit jeder Messkanalbaugruppe des Messgeräts über je eine Verbindungsleitung so verbunden, dass das Taktsignal den Messkanalbaugruppen zugeführt wird. Die Verbindungsleitungen zwischen dem Taktgenerator und der Messkanalbaugruppe weisen dabei identische Laufzeiten auf. Dies wird beispielsweise durch Koaxialkabel mit identischer Länge erreicht. Jede Messkanalbaugruppe weist eine Baugruppensignalquelle zur Erzeugung eines Baugruppentaktsignals und ein Phasenkorrekturglied auf, über das das Baugruppentaktsignal hinsichtlich seiner Phasenlage auf das Taktsignal korrigiert wird.

Das erfindungsgemäße Verfahren hat den Vorteil, dass die mehreren Messkanalbaugruppen mit gleicher Frequenz betrieben werden. Die relative Phase in jeder Messkanalbaugruppe des Messgeräts wird durch Zugrundelegen des Taktsignals als Phasenreferenz korrigiert. Das für die weitere Messaufgabe zur Verfügung stehende phasenkorrigierte Baugruppentaktsignal weist in jeder der Messkanalbaugruppen des Messgeräts eine identische Phasenlage auf. Auch schwierige Messaufgaben, wie beispielsweise in modernen Mobilfunksystemen, können damit durch ein solches mehrkanaliges Messsystem durchgeführt werden.

In den Unteransprüchen sind vorteilhafte Weiterbildungen des erfindungsgemäßen Messgeräts ausgeführt.

Insbesondere ist es vorteilhaft, dass das Phasenkorrekturglied eines jeden Messkanals einen Phasendetektor aufweist. In dem Phasendetektor wird zur Korrektur der Phasenlage des Baugruppentaktsignals das Baugruppentaktsignal oder ein daraus erzeugtes Ausgangstaktsignal und das Taktsignal des Messgeräts zugeführt. Das Ausgangstaktsignal ist dabei das Signal, welches in der jeweiligen Messkanalbaugruppe aus dem Baugruppentaktsignal z.B. durch einen Teiler erzeugt wird.

Weiterhin ist es vorteilhaft, dass durch den Phasendetektor ein Steuersignal zur Ansteuerung eines steuerbaren Phasenschiebers erzeugt wird. Der Phasenschieber ist ebenfalls Bestandteil des Phasenkorrekturglieds und mit dem Phasendetektor verbunden. Die Korrektur der Phasenlage des Baugruppentaktsignals erfolgt damit innerhalb einer jeden Messkanalbaugruppe. Somit kann als Baugruppentaktsignal den Messkanalbaugruppen ein Referenzsignal zugeführt werden, da unabhängig von den Laufzeitverschiebungen, die sich beispielsweise aufgrund unterschiedlicher Anordnungen der Messkanalbaugruppen innerhalb des Messgeräts ergeben, in einer lokalen Umgebung die erforderliche Phasenkorrektur durch den Phasendetektor innerhalb des Phasenkorrekturglieds ermittelt werden. Das Referenzsignal als Baugruppentaktsignal wird sozusagen vor Ort innerhalb der Messkanalbaugruppe hinsichtlich seiner Phasenlage korrigiert und steht anschließend für eine Messaufgabe der Messkanalbaugruppen synchron zur Verfügung.

Alternativ ist es auch möglich einen steuerbaren Oszillator vorzusehen, der das Baugruppentaktsignal messkanalbaugruppenintern generiert.

Weiterhin ist es vorteilhaft, dem Taktsignal, welches in dem Messgerät gemeinsam für die einzelnen Messkanalbaugruppen erzeugt wird, eine Markierung zu überlagern. Die Markierung weist eine gegenüber dem Taktsignal beispielsweise eine niedrigere Frequenz auf. Durch diese niedrigere Frequenz ist es möglich, für verschiedene Bearbeitungsschritte eine Steuerung für einen gemeinsamen Zeitpunkt zu synchronisieren. Mit einem solchen langsameren Zeitstempel, der mittels der Markierung dem Taktsignal überlagert bzw. eingeprägt wird, kann beispielsweise eine Messsoftware zeitlich angesteuert werden. Diese ist in der Lage, das langsamere Zeitstempelsignal zur Durchführung der Messaufgabe auszulesen oder in Steuerbefehle umzusetzen.

Das Taktsignal wird vorzugsweise aus einem Referenzsignal erzeugt. Beispielsweise kann ein hochfrequentes Referenzsignal, welches in dem Messgerät erzeugt oder diesem zugeführt wird, mit Hilfe eines Teilers auf eine niedrigere Frequenz geteilt werden. Das so aus dem Referenzsignal erzeugte Taktsignal des Messgeräts bildet dann die Phasenreferenz für die einzelnen Messkanalbaugruppen. Ein Taktsignalgenerator als Taktsignalquelle des Messgeräts ist hierzu mit einer Referenzsignalquelle verbunden.

Erfindungsgemäß können auch mehrere Messgeräte untereinander synchronisiert werden. Damit wird es also möglich, nicht nur mehrere Messkanäle innerhalb eines Messgeräts einschließlich der Phasenlage zu synchronisieren, sondern dies auch messgeräteübergreifend mit mehreren Messgeräten zu tun, wobei jedes Messgerät mehrere Messkanäle bzw. Messkanalbaugruppen aufweisen kann. Auch die Synchronisierung von mehreren Messgeräten mit jeweils nur einem Messkanal ist möglich. Hierzu wird von einem Messgerät zu jedem weiteren Messgerät des gesamten Messsystems und dem Messgerät selbst ein durch eine Systemsynchronisationssignalquelle erzeugtes Systemsynchronisationssignal übertragen. Die Laufzeit dieses Systemsynchronisationssignals ist dabei identisch. In jedem Messgerät ist eine Taktsignalquelle vorhanden, die ein Taktsignal erzeugt. Das Taktsignal wird dann mittels eines zweiten Phasenkorrekturglieds auf die Phasenlage des über einen Messgeräteeingang jedes Messgeräts zugeführten Systemssynchronisationssignals korrigiert.

Zur Synchronisation der einzelnen Messgeräte miteinander wird das in jedem Messgerät vorhandene bzw. dort erzeugte Taktsignal hinsichtlich seiner Phasenlage auf die Phasenlage des zugeführten Systemsynchronisationssignals korrigiert. Zur Korrektur der Phasenlage des Taktsignals wird in dem zweiten Phasenkorrekturglied das zugeführte Systemsynchronisationssignal sowie das Taktsignal einem Phasendetektor des zweiten Phasenkorrekturglieds zugeführt. Bei einer Erzeugung des Taktsignals aus dem Referenzsignal eines Messgeräts wird dabei erneut das dem Taktsignal zugrundeliegende Referenzsignal und damit das daraus abgeleitete Taktsignal des Messgeräts in Bezug auf seine Phasenlage korrigiert.

Es ist zu beachten, dass die Merkmale der Synchronisation von Messkanalbaugruppen innerhalb eines Geräts und die Synchronisation von mehreren Geräten miteinander vorzugsweise auch kombiniert werden können. Die Synchronisation der Geräte untereinander und die Synchronisation der Messkanalbaugruppen beruht auf demselben Prinzip. Die nachfolgenden Erläuterungen basieren auf einem Messgerät, mit dem sowohl eine Synchronisation mit weiteren Messgeräten eines Systems als auch von mehreren internen Messkanalbaugruppen möglich ist.

Eine bevorzugte Ausführungsform der Erfindung ist in der Zeichnung dargestellt und wird in der nachfolgenden Beschreibung näher erläutert. Es zeigen:
Fig. 1 ein Blockschaltbild eines erfindungsgemäßen Messgeräts mit mehreren Messkanalbaugruppen und einer Einrichtung zur Synchronisation mehrerer Messgeräte miteinander;
Fig. 2 eine Darstellung zur Erläuterung einer Synchronisation mehrerer Messgeräte miteinander; und
Fig. 3 eine Darstellung der in dem System zur Synchronisation verwendeten Signale.

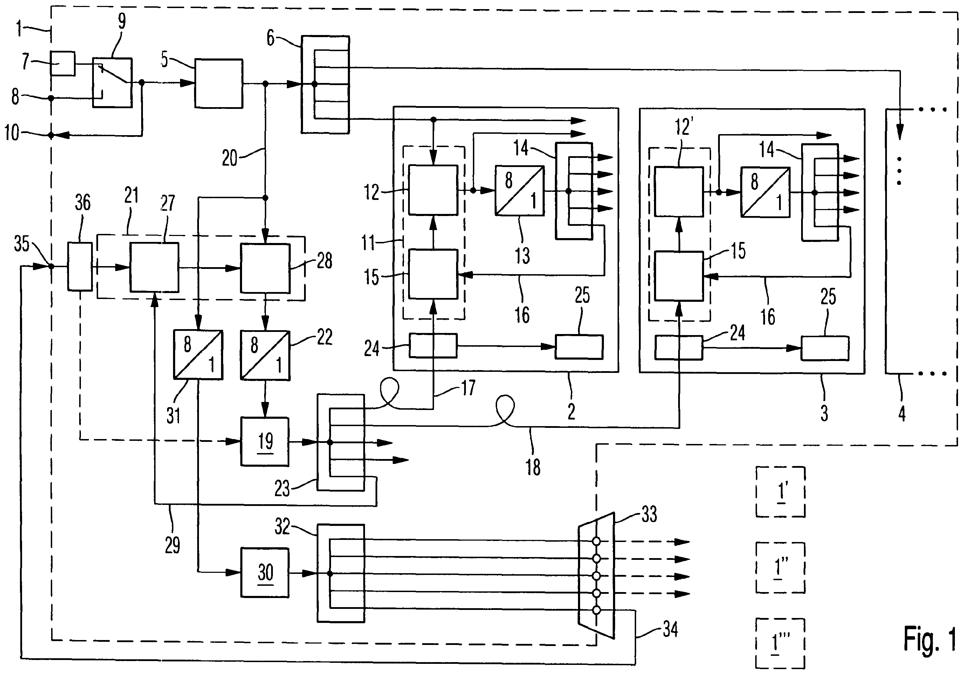

In der Fig. 1 ist schematisch der Aufbau eines Messgeräts 1 dargestellt. Das Messgerät 1 umfasst eine erste Messkanalbaugruppe 2 und eine zweite Messkanalbaugruppe 3. Wie es durch die noch weitere Messkanalgruppe 4 angedeutet ist, können zusätzliche Messkanalbaugruppen in dem Messgerät 1 angeordnet sein. Die Messkanalbaugruppen 2, 3, ... können hinsichtlich ihrer Einrichtung zur Synchronisation der Messkanalbaugruppen untereinander identisch aufgebaut sein. Über die in der Fig. 1 dargestellten Baugruppen oder Bauelemente können die Messkanalbaugruppen 2, 3, 4,... entsprechend ihrer jeweiligen Messaufgabe noch zusätzliche Einrichtungen aufweisen. Beispielsweise kann in jeder der Messkanalbaugruppen eine Sende- oder Empfangseinrichtung zur Kommunikation mit einem nicht dargestellten Mobilfunkgerät vorhanden sein. Auch können in jeder oder einzelnen Messkanalbaugruppen Auswerteeinrichtungen beispielsweise zur Ermittlung von Blockfehlerraten oder Bitfehlerraten bei der Übertragung von Daten zwischen dem Messgerät 1 und dem angeschlossenen Mobilfunkgerät vorhanden sein.

Um unnötige Wiederholungen zu vermeiden, werden die zur Synchronisation in den Messkanalbaugruppen 2, 3, .... jeweils vorhandenen Bauteile lediglich unter Bezugnahme auf die Messkanalbaugruppe 2 erläutert. Im Bezug auf die weiteren Messkanalbaugruppe 3 wird lediglich deren Abweichung von der ersten Messkanalbaugruppe 2 erläutert.

In dem Messgerät 1 ist eine Referenzsignalquelle 5 vorhanden. Diese Referenzsignalquelle 5 gibt ein Referenzsignal aus, welches der Synchronisierung der Messkanalbaugruppen 2, 3, 4 sowie mehrerer Messgeräte untereinander zugrunde gelegt wird. Zur Synchronisierung der Messkanalbaugruppen 2, 3, ... wird das Referenzsignal einem Verteiler 6 zugeführt. Der Verteiler 6 ist teilweise mit den einzelnen Messkanalbaugruppen 2, 4, ... verbunden und führt diesen der Messkanalbaugruppen 2, 4, ... das Referenzsignal zu. Die Laufzeit des Referenzsignals zu den einzelnen Messkanalbaugruppen 2, 4, ... kann dabei unterschiedlich sein.

Die Referenzsignalquelle 5 erzeugt das Referenzsignal auf Basis eines zugeführten Signals wie es beispielsweise geräteintern durch einen internen Signalgenerator 7 erzeugt wird. Auf Basis dieses Signals, das der Referenzsignalquelle 5 über einen Auswahlschalter 9 zugeführt wird, wird durch die Referenzsignalquelle 5 das Referenzsignal mit beispielsweise 800 MHz generiert. Dieses hochfrequente Referenzsignal bietet eine gute spektrale Reinheit, was für die weitere Anwendung und insbesondere das Erzeugen weiterer aus dem Referenzsignal abgeleiteter Frequenzen oder Signale vorteilhaft ist. Da bei dem erfindungsgemäßen Messgerät 1 das Referenzsignal den Messkanalbaugruppen 2, 4, ... nicht synchron zugeführt werden muss, ist die Anordnung der Messkanalbaugruppen 2, 4, ... innerhalb des Messgeräts variabel. Die Anordnung auf einer Leiterplatte des Messgeräts kann daher nach ökonomischen Gesichtspunkten durchgeführt werden, da eine identische Laufzeit des Referenzsignals zwischen dem ersten Verteiler 6 und den Messkanalbaugruppen 2, 4, ... nicht erforderlich ist.

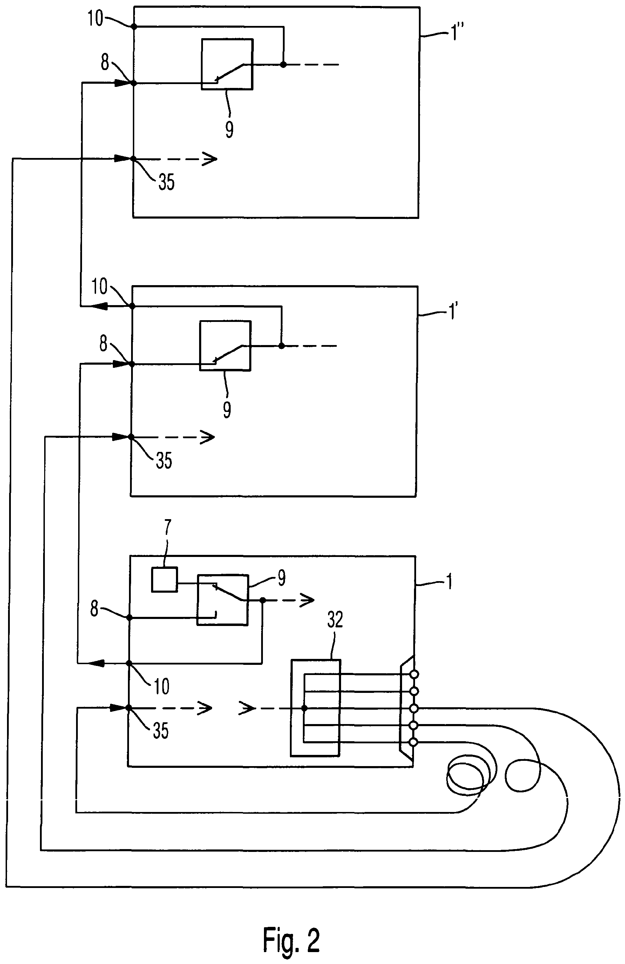

Während in der Fig. 1 dargestellt ist, dass über den Auswahlschalter 9 das Signal des Signalgenerators 7 der Referenzsignalquelle 5 zugeführt wird, ist zusätzlich ein Signaleingang 8 an dem Messgerät 1 vorgesehen. Über den Signaleingang 8 kann ebenfalls ein Signal über den Auswahlschalter 9 der Referenzsignalquelle 5 zugeführt werden. Dies wird nachfolgend unter Bezugnahme auf die Fig. 2 noch verdeutlicht. Der Signalgenerator 7 ist vorzugsweise ein frequenzstabiler Signalgenerator, wie beispielsweise ein OXCO ("Oven controlled oscillator").

Wird das dem Referenzsignal zugrundeliegende Signal in einem solchen OXCO eines Messgeräts 1 erzeugt, so kann dieses Signal gleichzeitig weiteren, mit dem Messgerät 1 verbundenen Messgeräten zugeführt werden. Hierzu wird das Signal zwischen dem Auswahlschalter 9 und der Referenzsignalquelle 5 abgegriffen und einem Signalausgang 10 des Messgeräts 1 zugeführt. Die Verwendung dieses Signalausgangs wird nachfolgend noch bei der Erläuterung der Synchronisation mehrerer Messgeräte 1 miteinander erläutert.

Zur Synchronisation der mehreren Messkanalbaugruppen 2, 3, ... miteinander ist in jeder Messkanalbaugruppe 2, 3, ... ein erstes Phasenkorrekturglied 11 angeordnet. Das Phasenkorrekturglied 11 weist einen Phasenschieber 12 auf, an dem das über den Verteiler 6 zugeführte Referenzsignal eingangsseitig anliegt. Im Falle des Zuführens des Referenzsignals wird ein Baugruppentaktsignal durch das Referenzsignal gebildet. Durch den Phasenschieber 12 wird das ankommende Referenzsignal vor der weiteren Verarbeitung in den Messkanalbaugruppen 2, 4, ... hinsichtlich seiner Phase verschoben. Das hinsichtlich seiner Phase korrigierte Referenzsignal kann, wie es in der Fig. 1 beispielhaft dargestellt ist, nachdem es durch den Phasenschieber 12 ausgegeben wird, entweder unmittelbar für weitere Aufgaben genutzt werden oder aber einem Teiler 13 zugeführt werden.

Wie es für die Messkanalbaugruppe 2 gezeigt ist, kann jedoch auch innerhalb der Messkanalbaugruppe ein Baugruppentaktsignal durch einen steuerbaren Oszillator 12' erzeugt werden. In dem dargestellten Ausführungsbeispiel wird in beiden Fällen durch den Teiler 13 ein niedrigerfrequentes Ausgangstaktsignal aus dem Baugruppentaktsignal der Messkanalbaugruppen 2, 3 erzeugt.

Dieses Ausgangstaktsignal wird einem zweiten Verteiler 14 zugeführt. Innerhalb des zweiten Verteilers 14 und insbesondere von dem zweiten Verteiler 14 ausgehend zu den weiteren das Ausgangstaktsignal als Zeitbasis verwendenden Baugruppen ist nun eine identische Signalweglänge erforderlich, so dass das über den zweiten Verteiler 14 verteilte Ausgangstaktsignal bei allen messrelevanten Baueinheiten phasengleich ankommt. Ein Zweig des zweiten Verteilers 14 wird über eine Verbindungsleitung 16 einem Phasendetektor 15 des ersten Phasenkorrekturglieds 11 zugeführt. Damit wird dem Phasenkorrekturglied 11 das Ausgangstaktsignal zugeführt, welches aus dem Referenzsignal zunächst mit unbekannter Phasenlage erzeugt wird. Sämtlichen Messkanalbaugruppen 2, 3, 4, ... wird ferner, wie es beispielhaft für die erste Messkanalbaugruppen 2 und die zweite Messkanalbaugruppe 3 gezeigt ist, über Leitungen 17 bzw. 18 mit identischer Signalweglänge ein Taktsignal des Messgeräts 1 zugeführt. Dieses Taktsignal führt damit allen Messkanalbaugruppen 2, 3, 4, ... ein Signal zu, welches bei den Messkanalbaugruppen 2, 3, ... mit identischer Phasenlage ankommt. Über die Leitung 17 wird dieses Taktsignal dem Phasendetektor 15 ebenfalls zugeführt. Der Phasendetektor 15 erzeugt somit aus dem Taktsignal, das über die Leitung 17 zugeführt wird, sowie dem über die Verbindungsleitung 16 zugeführten Ausgangstaktsignal eine Phasendifferenz. Auf Basis dieser Phasendifferenz wird durch den Phasendetektor 15 ein Steuersignal erzeugt, über den der steuerbare Phasenschieber 12 angesteuert wird. Auf Basis dieses Steuersignals wird das eingehende Referenzsignal im Falle der Messkanalbaugruppen 2 und 4 durch den Phasenschieber 12 so verschoben, dass das Baugruppentaktsignal und damit letztlich das Ausgangstaktsignal und das Taktsignal des Messgeräts 1 keine Phasenverschiebung aufweisen. Dabei müssen das Taktsignal und das Ausgangstaktsignal nicht notwendigerweise eine identische Frequenz aufweisen. Die Signale könnten beispielsweise auch in einem ganzzahligen Verhältnis zueinander stehen.

Im Falle der Erzeugung des Baugruppentaktsignals innerhalb der Messkanalbaugruppe 3 durch den steuerbaren Oszillator 12' wird durch den Phasendetektor 15 der steuerbare Oszillator 12' angesteuert. Auch hier kann eine Teilung durch einen Teiler vorgesehen sein. Es ist zu bemerken, dass eine Teilung vorgesehen sein kann, jedoch ebenso das Baugruppentaktsignal selbst dem Phasendetektor 15 zugeführt werden kann.

Zudem kann durch die Verbindungsleitung 16 auch eine Signalweglängenkompensation erfolgen, wenn beispielsweise die Signalweglänge für das Taktsignal innerhalb der einzelnen Messkanalbaugruppen 2,3,4... bis zu dem Phasendetektor 15 hin unterschiedlich ist.

Das durch die Referenzsignalquelle 5 erzeugte Referenzsignal wird im dargestellten Ausführungsbeispiel auch der Erzeugung des Taktsignals zugrunde gelegt. Über eine Leitung 20 ist hierzu ein Taktsignalgenerator 19 als Taktsignalquelle mit der Referenzsignalquelle 5 verbunden. In der Taktsignalquelle 19 wird das Taktsignal aus dem Referenzsignal erzeugt und einem zweiten Verteiler 23 zugeführt. Der zweite Verteiler 23 ist dabei so aufgebaut, dass das in dem Taktsignalgenerator 19 erzeugte Taktsignal mit identischen Laufzeiten an den Ausgängen des zweiten Verteilers 23 ausgegeben wird. Ferner sind die Leitungen 17, 18, ... von identischer Länge, so dass das Taktsignal mit identischer Phasenlage den einzelnen Messkanalbaugruppen 2, 3, ... zugeführt wird. Als Leitungen 17, 18 können beispielsweise Koaxialkabel in dem Messgerät 1 verlegt werden.

In der Verbindungsleitung 20 ist ein zweiter Teiler 22 vorgesehen, welcher aus dem hochfrequenten Referenzsignal eine niedrigere Frequenz erzeugt, welche dann durch den Taktsignalgenerator 19 zu einem Taktsignal niedrigerer Frequenz weiterverarbeitet wird. Eine solche Frequenzteilung ist optional. Durch die Verwendung eines Taktsignals niedrigerer Frequenz, beispielsweise 100 MHz, ist es einfacher, Laufzeitlängen innerhalb des Messgeräts zu kontrollieren. Das aus dem Referenzsignal erzeugte niedrigerfrequente Taktsignal bietet somit die Möglichkeit, eine gemeinsame Zeitbasis für die Messkanalbaugruppen 2, 3, ... zu schaffen, obwohl zur Durchführung der Messaufgabe jeder der Messkanalbaugruppen 2, 3, ... das hochfrequente Referenzsignal individuell zugeführt oder ein Baugruppentaktsignal neu erzeugt wird.

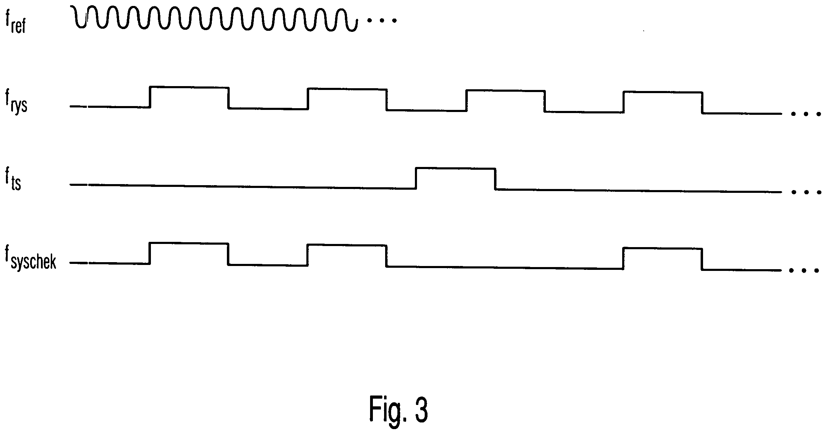

Dem Taktsignal kann zusätzlich durch den Taktsignalgenerator 19 eine Markierung überlagert werden. Eine solche Markierung kann mittels eines Zeitstempelsignals erfolgen. Die Überlagerung eines Zeitstempelsignals kann beispielsweise eine in einem als Rechtecksignal ausgeführten Taktsignal vorgesehene Austastlücke sein. Dies wird nachfolgend noch unter Bezugnahme auf die Fig. 3 verdeutlicht. Ein solches Zeitstempelsignal ist hinsichtlich seiner Frequenz noch einmal gegenüber dem Taktsignal reduziert, so dass das Zeitstempelsignal den Messkanalbaugruppen 2, 3, ... mit einer Frequenz zugeführt wird, die durch eine Messsoftware verarbeitet werden kann. Um in jeder Messkanalbaugruppe 2, 3, ... den Zeitstempel erfassen zu können, ist ein Zeitstempeldetektor 24 vorgesehen. Der Zeitstempeldetektor 24 erkennt die Austastlücke und führt sie weiteren Komponenten 25 wie beispielsweise einem zentralen Prozessor zu.

Die Markierung kann z.B. auch mittels eines Protokolls übertragen werden. Beispielsweise kann die Markierung durch eine Pulscode Modulation erfolgen.

Während die bisherige Beschreibung der Synchronisation von mehreren Messkanalbaugruppen 2, 3, ... innerhalb eines Messgerätes erläutert wurde, ist jedes der Messgeräte 1 so eingerichtet, dass auch mehrere Messgeräte 1 miteinander auf eine gemeinsame Zeitbasis synchronisiert werden können. Hierzu ist ein zweites Phasenkorrekturglied 21 in der Verbindungsleitung 20 vorgesehen. Mit Hilfe des zweiten Phasenkorrekturglieds 21 wird das zur Erzeugung des Taktsignals in jedem der Messgeräte 1 verwendete Referenzsignal in der Verbindungsleitung 20 vor der Erzeugung des Taktsignals auf eine identische Phasenlage gebracht. Das zweite Phasenkorrekturglied 21 umfasst hierzu wiederum einen Phasendetektor 27, dessen Steueranschluss mit einem steuerbaren Phasenschieber 28 verbunden ist. Die Verbindungsleitung 20 führt das Referenzsignal dem steuerbaren Phasenschieber 28 zu, bevor das so abgezweigte Referenzsignal dem Teiler 22 bzw. dem Taktsignalgenerator 19 zugeführt wird. Zum Erzeugen des Steuersignals für den steuerbaren Phasenschieber 28 ist der zweite Verteiler 23 über eine Taktsignalrückführungsleitung 29 mit dem Phasendetektor 27 des zweiten Phasenkorrekturglieds 21 verbunden. Die Taktsignalrückführungsleitung 29 weist eine mit den Leitungen 17, 18 identische Länge auf.

Als Vergleichsbasis dient dem Phasendetektor 27 ein Systemsynchronisationssignal, welches über einen Systemsynchronisationssignalgenerator 30 erzeugt wird. Das Systemsynchronisationssignal wird ebenfalls auf Basis des von der Referenzsignalquelle 5 erzeugten Referenzsignals generiert. Die Verbindungsleitung 20 verzweigt sich hierzu und führt das direkt von der Referenzsignalquelle 5 erzeugte Referenzsignal über einen weiteren Teiler 31 dem Systemsignalgenerator 30 zu. Der weitere Teil 31 ist dabei wiederum bevorzugt vorgesehen, um ein niedrigerfrequentes Systemsynchronisationssignal aus dem Referenzsignal zu erzeugen. Das durch den Systemsynchronisationssignalgenerator 30 erzeugte Systemsynchronisationssignal wird einem dritten Verteiler 32 zugeführt. Die Laufzeiten des Systemsynchronisationssignals ab dem Systemsynchronisationssignalgenerator 30 sind wiederum identisch. Von dem dritten Verteiler 32 aus werden zunächst für jeden Zweig des dritten Verteilers 32 Verbindungen zu Messgerätausgangsanschlüssen 33 vorgesehen. Die Anzahl der Messgerätausgangsanschlüsse 33 entspricht dabei der Anzahl maximal miteinander zu koppelnder Messgeräte 1. Über eine Rückführungsleitung 34 wird das Systemsynchronisationssignal extern einem Messgeräteeingang 35 zugeführt. Zur Synchronisation mehrerer Messgeräte 1 miteinander erfolgt dies für jedes der miteinander gekoppelten Messgeräte, wie es nachfolgend noch bei der Erläuterung der Fig. 2 beschrieben wird. Dieses rückgeführte Systemsynchronisationssignal bietet die Basis zur Bestimmung der Phasenlage für das Taktsignal der Messgeräte 1.

Im Beispiel ist ein geräteinterner dritter Verteiler vorgesehen. Es ist jedoch selbstverständlich, die Systemsynchronisationssignalquelle mit einem einzigen Messgeräteausgang zu verbinden und einen externen weiteren Verteiler vorzusehen. Entscheidend ist, dass das Systemsynchronisationssignal ab der Systemsynchronisationssignalquelle bis hin zu den Messgeräteeingängen der angeschlossenen Messgeräte bzw. zu dem jeweiligen Phasendetektor eine identische Signalweglänge durchläuft.

Dazu wird das zurückgeführte Systemsynchronisationssignal mit dem intern rückgeführten Taktsignal in dem Phasendetektor 27 miteinander verglichen. Bei einer Abweichung der Phasenlage dieser beiden Signale relativ zueinander wird durch den Phasendetektor 27 wie schon durch den ersten Phasendetektor 15 ein Steuersignal ausgegeben. Das Steuersignal wird dem Phasenschieber 28 des zweiten Phasenkorrekturglieds 21 zugeführt. Infolgedessen wird das dem Phasenschieber 28 zugeführte Referenzsignal in seiner Phase so weit verschoben, bis das zurückgeführte Taktsignal und das zurückgeführte Systemsynchronisationssignal eine vernachlässigbare Phasendifferenz aufweisen.

Da den miteinander zu synchronisierenden Messgeräten 1 jeweils über eine Systemsynchronisationssignalrückführungsleitung 34 ein Systemsynchronisationssignal identischer Phasenlage zugeführt wird, erzeugt der jeweils geräteinterne Abgleich des Taktsignals hinsichtlich seiner Phasenlage auf das Systemsynchronisationssignal gleichlaufende Messgeräte. Zudem wird auf Basis des so hinsichtlich seiner Phasenlage gleichlaufenden Taktsignals der einzelnen Messgeräte eine Phasenkorrektur des Referenzsignals in den einzelnen Messkanalbaugruppen 2, 3, ... der Messgeräte 1 durchgeführt. Letztlich sind somit alle Messkanalbaugruppen 2, 3, ... aller Messgeräte 1, die miteinander gekoppelt sind, hinsichtlich ihrer Phasenlage identisch. Die Messung kann somit auf einem identischen Zeitschema durchgeführt werden. Zum Steuern komplexerer Messaufgaben ist es dabei insbesondere auch vorteilhaft, dass dem jeweiligen Taktsignal ein Austastimpuls zugeführt wird. Um dies wiederum messgeräteübergreifend durchführen zu können, wird vorzugsweise durch den Systemsynchronisationssignalgenerator 30 ein Austastimpuls dem Systemsynchronisationssignal zugefügt. Dieser wird durch eine entsprechende Vorrichtung 36 ausgelesen, wobei das Ergebnis dem Taktsignalgenerator 19 zugeführt wird. Dieser erzeugt auf Basis des Austastimpulses des Systemsynchronisationssignals in dem Taktsignal eines jeden Messgeräts 1 einen Austastimpuls. Damit liegt in jedem der Messgeräte 1 zu einem identischen Zeitpunkt ein Austastimpuls vor, der durch die einzelnen Messkanalbaugruppen 2, 3, ... ausgewertet werden kann.

Die Messgeräteanschlüsse 33 sind mit mehreren Messgeräten 1', 1", 1''' verbindbar, wie es durch die gestrichelten weiteren Messgeräte dargestellt ist. Die Verbindung der Messgeräte 1, 1', 1", ... miteinander ist in der Fig. 2 zur Verdeutlichung dargestellt.

Das in der Fig. 2 zu unterst dargestellte Messgerät 1 entspricht in seinem Aufbau, wie auch die weiteren Messgeräte 1', 1", dem in der Fig. 1 ausführlich erläuterten. Dabei fungiert das Messgerät 1 als "Master", wohingegen die weiteren Messgeräte 1' und 1" als sog. "Slave"-Messgeräte betrieben werden.

Durch das Messgerät 1 wird in einem Verbund aus mehreren Messgeräten einerseits das den Referenzsignalquellen 5 zugrundeliegende Signal durch den Signalgenerator 7 erzeugt. Entsprechend ist die Referenzsignalquelle 5 des Messgeräts 1 mit der Signalquelle 7 über den Auswahlschalter 9 verbunden. Das durch den Signalgenerator 7 erzeugte Signal wird über den Signalausgang 10 dem Signaleingang 8 des Messgeräts 1' und über dessen Signalausgang 10 dem Signaleingang 8 des Messgeräts 1" zugeführt. Dementsprechend befinden sich die Auswahlschalter 9 der Messgeräte 1', 1" in ihrer jeweils anderen Position. Ausgehend von dem Signal des Signalgenerators 7 erzeugen damit sämtliche Referenzsignalquellen 5 der Messgeräte 1, 1', 1" ein Referenzsignal mit identischer Frequenz von beispielsweise 800 MHz.

Zur Synchronisation der einzelnen Messkanalbaugruppen 2, 3, ... jeden Messgeräts 1, 1', 1" wird innerhalb der einzelnen Messgeräte 1, 1', 1" in für das Messgerät 1 ausführlich beschriebener Weise ein Taktsignal erzeugt. Dieses Taktsignal, welches geräteintern erzeugt wird, ermöglicht dabei die geräteinterne Synchronisation sämtlicher Messkanalbaugruppen 2, 3, ... jeweils eines Messgeräts.

Die Synchronisation der mehreren Messgeräte 1, 1', 1" erfolgt dagegen durch ein zusätzlich durch das "Master"-Messgerät 1 erzeugte Systemsynchronisationssignal. Dieses Systemsynchronisationssignal wird durch das Messgerät 1 in bereits erläuterter Weise erzeugt und über den dritten Verteiler 32 an mehreren Ausgangsanschlüssen 33 zur Verfügung gestellt. Jeweils einer dieser Ausgangsanschlüsse 33 ist über ein Systemsynchronisationssignalrückführkabel 34 mit dem Messgeräteeingang 35 des Messgeräts 1, dem Messgeräteeingang 35 des Messgeräts 1' und dem Messgeräteeingang 35 des Messgeräts 1" verbunden. Die zur Verbindung der Ausgangsanschlüsse 33 mit den Messgeräteanschlüssen 35 verwendeten Kabel weisen dabei eine identische Länge auf. Die Laufzeit der Systemsynchronisationssignale zu den einzelnen Messgeräten ist daher identisch. Damit wird über das Systemsynchronisationssignal ein Abgleich der Phasenlagen des Taktsignals in den Messgeräten durch das jeweils zweite Phasenkorrekturglied 21 ermöglicht. Da anschließend intern auf Basis des jeweiligen phasenkorrigierten Taktsignals eine Phasenkorrektur des Referenzsignals und damit eine interne Synchronisation der Messkanalbaugruppen 2, 3, ... eines Messgeräts 1, 1', 1" erfolgt, werden letztlich sämtliche Messkanalbaugruppen aller Messgeräte 1, 1', 1" miteinander synchronisiert.

Es ist ersichtlich, dass die Synchronisation von Messgeräten weder auf die gezeigte Anzahl von Messkanalbaugruppen eines Messgeräts noch auf die gezeigte Anzahl von Messgeräten beschränkt ist.

In der Fig. 3 ist beispielhaft gezeigt, wie aus einem gemeinsamen Referenzsignal in dem "Master"-Messgerät 1 die zur Synchronisation der Geräte bzw. der Messkanalbaugruppen 2, 3, ... miteinander erforderlichen Signale erzeugt werden. Ausgangspunkt ist ein Referenzsignal F_{ref}, das beispielsweise 800 MHz aufweist. Dieses Signal ist von spektral hoher Reinheit und dient als Basis zur Erzeugung eines auswählbaren Zeitrasters der Messkanalbaugruppen 2, 3, ... sowie des Taktsignals F_{sys}. Das Taktsignal F_{sys} wird durch den Taktsignalgenerator 19 auf Basis eines frequenzgeteilten Referenzsignals F_{ref} erzeugt und hat beispielsweise eine Frequenz von 100 MHz. Diesem Taktsignal F_{sys} wird ein Zeitstempelsignal Fₜₛ überlagert, das z.B. nur noch eine Frequenz von 1 kHz aufweist. Bei Auftreten eines Zeitstempelsignals wird durch den Taktsignalgenerator 19 ein Austastimpuls in dem Taktsignal erzeugt, bevor schließlich das modifizierte Taktsignal F_{sys CLK} durch den Taktsignalgenerator 19 ausgegeben wird.

In ähnlicher Weise wird ausgehend von dem Referenzsignal auch das Systemsynchronisationssignal erzeugt. Dabei kann auch dem Systemsynchronisationssignal ein Zeitstempelsignal überlagert werden. Auf Basis dieses überlagerten Zeitstempelsignals ist es möglich, sämtliche Zeitstempel in den einzelnen Messgeräten 1, 1', 1" zeitlich identisch zu positionieren.

Durch die messgerätübergreifende Systemsynchronisation auf das Systemsynchronisationssignal werden durch die Verteilung eines phasengleichen Systemsynchronisationssignals interne Laufzeitunterschiede der einzelnen Messgeräte ausgeglichen. Da dies ebenso für die internen unterschiedlichen Laufzeiten der Referenzsignale zu den Messkanalbaugruppen 2, 4, ... durchgeführt wird, wird eine messgerätübergreifende Systemsynchronisation aller Messkanalbaugruppen 2, 3, 4, ... erreicht.

## Patentansprüche

1. Verfahren zur Synchronisation von mehreren Messgeräten (1, 1', 1") mit zumindest jeweils zwei Messkanalbaugruppen (2, 3, 4) mit folgenden Verfahrensschritten:
- Erzeugen eines Systemsynchronisationssignals durch ein Messgerät (1);
- Zuführen des Systemsynchronisationssignals zu jedem weiteren Messgerät (1', 1") und dem Messgerät zur Erzeugung des Systemsynchronisationssignals selbst (1), wobei die Laufzeiten des Systemsynchronisationssignals zu allen Messgeräten (1, 1', 1") gleich sind;
- Erzeugen jeweils eines Taktsignals in den Messgeräten (1, 1', 1"); und
- Korrigieren der Phasenlage des Taktsignals jedes Messgeräts (1, 1', 1") auf die Phasenlage des Systemsynchronisationssignals
**wobei** das Systemsynchronisationssignal dem Messgerät (1) zur Erzeugung des Systemsynchronisationssignals über einen Messgeräteausgang (33) und über einen Messgeräteeingang (35) extern zurückgeführt wird; und
**dadurch gekennzeichnet,**
**dass** das Systemsynchronisationssignal dem Messgerät zur Erzeugung des Systemsynchronisationssignals (1) über den Messgeräteeingang (35) zu einem Phasenkorrekturglied (21) zugeführt wird; und
**dass** für die Synchronisation der Messkanalbaugruppen (2, 3, 4) in den Messgeräten (1, 1', 1"), ein zusätzlicher Verfahrensschritt des Zuführens des phasenkorrigierten Taktsignals zu den Messkanalbaugruppen (2, 3, 4) ausgeführt wird, wobei die Laufzeiten des Taktsignals zu den Messkanalbaugruppen (2, 3, 4) gleich lang sind.

2. Verfahren nach Anspruch 1,
**dadurch gekennzeichnet,**
**dass** die Phasenlage des Taktsignals eines jeden Messgeräts (1, 1', 1") auf die Phasenlage des zugeführten Systemsynchronisationssignals korrigiert wird.

3. Verfahren nach Anspruch 1 oder 2,
**dadurch gekennzeichnet,**
**dass** zur Synchronisation von mehreren Messkanalbaugruppen (2, 3, 4) in den Messgeräten (1, 1', 1") "nach Korrektur der Phasenlage des Taktsignals jeder Messbaugruppe (2, 3, 4)" zusätzlich die folgenden Verfahrensschritte durchgeführt werden:
- Erzeugen jeweils eines Baugruppentaktsignals in den Messkanalbaugruppen (2, 3, 4); und
- Korrigieren der Phasenlage des Baugruppentaktsignals in jeder Messkanalbaugruppe (2, 3, 4) auf die Phasenlage des Taktsignals.

4. Verfahren nach Anspruch 3,
**dadurch gekennzeichnet,**
**dass** ein Referenzsignal erzeugt wird und zumindest in einem Teil der Messkanalbaugruppen (2, 3, 4) aus dem Referenzsignal das Baugruppentaktsignal erzeugt wird.

5. Verfahren nach Anspruch 3 oder 4,
**dadurch gekennzeichnet,**
**dass** zumindest in einem Teil der Messkanalbaugruppen (2, 3, 4) durch einen steuerbaren Oszillator das Baugruppentaktsignal erzeugt wird.

6. Verfahren nach einem der Ansprüche 3 bis 5,
**dadurch gekennzeichnet,**
**dass** zur Korrektur der Phasenlage das Taktsignal und das jeweilige Baugruppentaktsignal oder ein daraus erzeugtes Ausgangstaktsignal der Messkanalbaugruppe (2, 3, 4) einem Phasendetektor (15) zugeführt wird.

7. Verfahren nach Anspruch 6,
**dadurch gekennzeichnet,**
**dass** durch den Phasendetektor (15) ein Steuersignal zur Ansteuerung eines steuerbaren Phasenschiebers (12) erzeugt wird.

8. Verfahren nach einem der Ansprüche 6 oder 7,
**dadurch gekennzeichnet,**
**dass** das Referenzsignal einem Eingang eines steuerbaren Phasenschiebers (12) einer Messkanalbaugruppe (2, 3, 4) zugeführt wird.

9. Verfahren nach Anspruch 6,
**dadurch gekennzeichnet,**
**dass** das Baugruppentaktsignal durch einen steuerbaren Oszillator (12') erzeugt wird, dem zur Ansteuerung das Steuersignal des Phasendetektors (15) zugeführt wird.

10. Verfahren nach einem der Ansprüche 3 bis 9,
**dadurch gekennzeichnet,**
**dass** dem Taktsignal eine Markierung überlagert wird.

11. Verfahren nach einem der Ansprüche 3 bis 9,
**dadurch gekennzeichnet,**
**dass** das Taktsignal aus dem Referenzsignal erzeugt wird.

12. Messgerät mit einer Taktsignalquelle (19) zum Erzeugen eines Taktsignals, einer Systemsynchronisationssignalquelle, die mit zumindest einem Messgeräteausgang verbunden ist und einem Phasenkorrekturglied (21) zur Anpassung der Phasenlage des Taktsignals;
**gekennzeichnet durch,**
einen Messgeräteeingang (35) verbunden mit dem Phasenkorrekturglied (21) zur Anpassung der Phasenlage des Taktsignals auf die Phasenlage des über den Messgeräteeingang (35) extern zugeführten Signals; und
dass das Messgerät zumindest zwei Messkanalbaugruppen (2, 3, 4) aufweist und die Taktsignalquelle (19) mit jeder Messkanalbaugruppe (2, 3, 4) über jeweils eine Verbindungsleitung (17, 18) gleicher Signalweglänge verbunden ist.

13. Messgerät nach Anspruch 12,
**dadurch gekennzeichnet,**
**dass** eine Referenzsignalquelle (5) jeweils mit der Taktsignalquelle (19) und der Systemsynchronisationssignalquelle (30) verbunden ist.

14. Messgerät nach Anspruch 12 oder 13,
**dadurch gekennzeichnet,**
**dass** jede Messkanalbaugruppe (2, 3, 4) eine Baugruppensignalquelle (12, 12') zur Erzeugung eines Baugruppentaktsignals und ein weiteres Phasenkorrekturglied (11) zur Anpassung der Phasenlage des Baugruppentaktsignals auf die Phasenlage des Taktsignals aufweist.

15. Messgerät nach Anspruch 14,
**dadurch gekennzeichnet,**
**dass** das Phasenkorrekturglied (11) einer jeden Messkanalbaugruppe (2, 3, 4) einen Phasendetektor (15) aufweist.

16. Messgerät nach Anspruch 15,
**dadurch gekennzeichnet,**
**dass** das weitere Phasenkorrekturglied (11) einen Phasenschieber (12) oder einen steuerbaren Oszillator (12') aufweist, der mit dem Phasendetektor (15) verbunden ist.

17. Messgerät nach Anspruch 16,
**dadurch gekennzeichnet,**
**dass** eine Referenzsignalquelle (5) mit jeweils einem Eingangsanschluss des Phasenschiebers (12) einer jeden Messkanalbaugruppe (2, 3, 4) verbunden ist.

## Claims

1. Method for synchronising a plurality of measuring devices (1, 1', 1") with at least two measuring channel assemblies (2, 3, 4) in each case with the following method steps:
- generation of a system synchronisation signal by a measuring device (1);
- feeding of the system synchronisation signal to each further measuring device (1', 1") and to the measuring device for generating the system synchronisation signal itself (1), wherein the transit times of the system synchronisation signal to all the measuring devices (1, 1', 1") are the same;
- generation of a clock signal in each of the measuring devices (1, 1', 1"); and
- correction of the phase position of the clock signal of each measuring device (1, 1', 1") to the phase position of the system synchronisation signal,
wherein the system synchronisation signal is fed back to the measuring device (1) for generating the system synchronisation signal externally via a measuring device output (33) and via a measuring device input (35); and
**characterised in that**
the system synchronisation signal is fed to the measuring device for generating the system synchronisation signal via the measuring device input (35) to a phase correction element (21); and
**in that** for synchronisation of the measuring channel assemblies (2, 3, 4) in the measuring devices (1, 1', 1"), an additional method step of feeding the phase-corrected clock signal to the measuring channel assemblies (2, 3, 4) is carried out, wherein the transit times of the clock signal to the measuring channel assemblies (2, 3, 4) are the same length.

2. Method according to claim 1,
**characterised in that**
the phase position of the clock signal of each measuring device (1, 1', 1") is corrected to the phase position of the system synchronisation signal that was fed [to it].

3. Method according to claim 1 or 2,
**characterised in that**
for synchronising a plurality of measuring channel assemblies (2, 3, 4) in the measuring devices (1, 1', 1") "after correction of the phase position of the clock signal of each measuring channel assembly (2, 3, 4)" the following method steps are also carried out:
- generation of an assembly clock signal in each of the measuring channel assemblies (2, 3, 4); and
- correction of the phase position of the assembly clock signal in each measuring channel assembly (2, 3, 4) to the phase position of the clock signal.

4. Method according to claim 3,
**characterised in that**
a reference signal is generated and at least in a part of the measuring channel assemblies (2, 3, 4) the assembly clock signal is generated from the reference signal.

5. Method according to claim 3 or 4,
**characterised in that**
at least in a part of the measuring channel assemblies (2, 3, 4) the assembly clock signal is generated by a controllable oscillator.

6. Method according to one of claims 3 to 5,
**characterised in that**
for correction of the phase position the clock signal and the respective assembly clock signal or an output clock signal of the measuring channel assembly (2, 3, 4) generated from it is fed to a phase detector (15).

7. Method according to claim 6,
**characterised in that**
a control signal for actuating a controllable phase shifter (12) is generated by the phase detector (15).

8. Method according to one of claims 6 or 7,
**characterised in that**
the reference signal is fed to an input of a controllable phase shifter (12) of a measuring channel assembly (2, 3, 4).

9. Method according to claim 6,
**characterised in that**
the assembly clock signal is generated by a controllable oscillator (12') to which the control signal of the phase detector (15) is fed for actuation.

10. Method according to one of claims 3 to 9,
**characterised in that**
a marking is superimposed on the clock signal.

11. Method according to one of claims 3 to 9,
**characterised in that**
the clock signal is generated from the reference signal.

12. Measuring device with a clock signal source (19) for generating a clock signal, a system synchronisation signal source which is connected with at least one measuring device output, and a phase correction element (21) for matching the phase position of the clock signal;
**characterised by**
a measuring device input (35) connected with the phase correction element (21) for matching the phase position of the clock signal to the phase position of the signal fed externally via the measuring device input (35); and in that the measuring device has at least two measuring channel assemblies (2, 3, 4) and the clock signal source (19) is connected with each measuring channel assembly (2, 3, 4) via a connecting line (17, 18) with the same signal path length in each case.

13. Measuring device according to claim 12,
**characterised in that**
a reference signal source (5) is connected in each case with the clock signal source (19) and the system synchronisation signal source (30).

14. Measuring device according to claim 12 or 13,
**characterised in that**
each measuring channel assembly (2, 3, 4) has an assembly signal source (12, 12') for generating an assembly clock signal and a further phase correction element (13) for matching the phase position of the assembly clock signal to the phase position of the clock signal.

15. Measuring device according to claim 14,
**characterised in that**
the phase correction element (11) of each measuring channel assembly (2, 3, 4) has a phase detector (15).

16. Measuring device according to claim 15,
**characterised in that**
the further phase correction element (11) has a phase shifter (12) or a controllable oscillator (12') which is connected with the phase detector (15).

17. Measuring device according to claim 16,
**characterised in that**
a reference signal source (5) is connected in each case with an input port of the phase shifter (12) of each measuring channel assembly (2, 3, 4).

## Revendications

1. Procédé pour synchroniser plusieurs appareils de mesure (1, 1', 1") avec au moins respectivement deux modules de canal de mesure (2, 3, 4), comprenant les étapes de procédé suivantes :
- production d'un signal de synchronisation du système, par un appareil de mesure (1) ;
- amenée du signal de synchronisation du système à chaque autre appareil de mesure (1', 1") et à l'appareil de mesure destiné à produire le signal de synchronisation du système lui-même (1), les durées de marche du signal de synchronisation du système vers tous les appareils de mesure (1, 1', 1") étant identiques ;
- production respectivement d'un signal d'horloge dans les appareils de mesure (1, 1', 1") ; et
- correction de la position de phase du signal d'horloge de chaque appareil de mesure (1, 1', 1") à la position de phase du signal de synchronisation du système,
procédé d'après lequel le signal de synchronisation du système est ramené par voie externe à l'appareil de mesure (1) destiné à produire le signal de synchronisation du système, par l'intermédiaire d'une sortie d'appareil de mesure (33) et par l'intermédiaire d'une entrée d'appareil de mesure (35) ; et
**caractérisé**
**en ce que** le signal de synchronisation du système est amené à l'appareil de mesure (1) destiné à produire le signal de synchronisation du système, par l'intermédiaire de l'entrée d'appareil de mesure (35) vers un organe de correction de phase (21) ; et
**en ce que** pour la synchronisation des modules de canal de mesure (2, 3, 4) dans les appareils de mesure (1, 1', 1"), on exécute une étape de procédé supplémentaire consistant à amener le signal d'horloge corrigé en phase aux modules de canal de mesure (2, 3, 4), les temps de marche du signal d'horloge vers les modules de canal de mesure (2, 3, 4) étant d'une durée identique.

2. Procédé selon la revendication 1,
**caractérisé**
**en ce que** la position de phase du signal d'horloge de chaque appareil de mesure (1, 1', 1") est corrigée à la position de phase du signal de synchronisation du système ayant été amené.

3. Procédé selon la revendication 1 ou la revendication 2,
**caractérisé**
**en ce que** pour la synchronisation de plusieurs modules de canal de mesure (2, 3, 4) dans les appareils de mesure (1, 1', 1") "après correction de la position de phase du signal d'horloge de chaque module de mesure (2, 3, 4)", on exécute en supplément les étapes de procédé suivantes :
- production respective d'un signal d'horloge de module dans les modules de canal de mesure (2, 3, 4) ; et
- correction de la position de phase du signal d'horloge de module dans chaque module de canal de mesure (2, 3, 4), à la position de phase du signal d'horloge.

4. Procédé selon la revendication 3,
**caractérisé**
**en ce que** l'on produit un signal de référence, et dans au moins une partie des modules de canal de mesure (2, 3, 4), on produit le signal d'horloge de module à partir du signal de référence.

5. Procédé selon la revendication 3 ou la revendication 4,
**caractérisé**
**en ce que** dans au moins une partie des modules de canal de mesure (2, 3, 4), le signal d'horloge de module est produit par un oscillateur pouvant être commandé.

6. Procédé selon l'une des revendications 3 à 5,
**caractérisé**
**en ce que** pour la correction de la position de phase, le signal d'horloge et le signal d'horloge de module respectif ou un signal d'horloge de sortie du module de canal de mesure (2, 3, 4) produit à partir de là, est amené à un détecteur de phase (15).

7. Procédé selon la revendication 6,
**caractérisé**
**en ce que** le détecteur de phase (15) produit un signal de commande pour assurer la commande d'un décaleur de phase (12) pouvant être commandé.

8. Procédé selon l'une des revendications 6 ou 7,
**caractérisé**
**en ce que** le signal de référence est amené à une entrée d'un décaleur de phase (12) pouvant être commandé, d'un module de canal de mesure (2, 3, 4).

9. Procédé selon la revendication 6,
**caractérisé**
**en ce que** le signal d'horloge de module est produit par un oscillateur (12') pouvant être commandé et auquel est amené pour assurer sa commande, le signal de commande du détecteur de phase (15).

10. Procédé selon l'une des revendications 3 à 9,
**caractérisé**
**en ce qu'**au signal d'horloge est superposé un marqueur.

11. Procédé selon l'une des revendications 3 à 9,
**caractérisé**
**en ce que** le signal d'horloge est produit à partir du signal de référence.

12. Appareil de mesure comprenant une source de signal d'horloge (19) pour produire un signal d'horloge, une source de signal de synchronisation du système, qui est reliée à au moins une sortie d'appareil de mesure et au moins un organe de correction de phase (21) pour l'adaptation de la position de phase du signal d'horloge ;
**caractérisé**
**par** une entrée d'appareil de mesure (35) reliée à l'organe de correction de phase (21) pour adapter la position de phase du signal d'horloge à la position de phase du signal amené par voie externe, par l'intermédiaire de l'entrée d'appareil de mesure (35) ; et
en ce que l'appareil de mesure comprend au moins deux modules de canal de mesure (2, 3, 4), et la source de signal d'horloge (19) est reliée à chaque module de canal de mesure (2, 3, 4), respectivement par l'intermédiaire d'un conducteur de liaison (17, 18) de même longueur de parcours de signal.

13. Appareil de mesure selon la revendication 12,
**caractérisé**
**en ce qu'**une source de signal de référence (5) est reliée respectivement à la source de signal d'horloge (19) et à la source de signal de synchronisation du système (30).

14. Appareil de mesure selon la revendication 12 ou la revendication 13,
**caractérisé**
**en ce que** chaque module de canal de mesure (2, 3, 4) comprend une source de signal de module (12, 12') pour produire un signal d'horloge de module, et un autre organe de correction de phase (11) pour l'adaptation de la position de phase du signal d'horloge de module à la position de phase du signal d'horloge.

15. Appareil de mesure selon la revendication 14,
**caractérisé**
**en ce que** l'organe de correction de phase (11) de chaque module de canal de mesure (2, 3, 4) comporte un détecteur de phase (15).

16. Appareil de mesure selon la revendication 15,
**caractérisé**
**en ce que** ledit autre organe de correction de phase (11) comprend un décaleur de phase (12) ou un oscillateur (12') pouvant être commandé et relié au détecteur de phase (15).

17. Appareil de mesure selon la revendication 16,
**caractérisé**
**en ce qu'**une source de signal de référence (5) est reliée respectivement à une borne d'entrée du décaleur de phase (12) de chaque module de canal de mesure (2, 3, 4).
